# EUROPÄISCHE PATENTSCHRIFT

(11) **EP 2 918 148 B1**
(45) Veröffentlichungstag und Bekanntmachung des Hinweises auf die Patenterteilung: **03.08.2016**
(21) Anmeldenummer: 13821432.5
(22) Anmeldetag: 04.11.2013
(51) Int. Cl.: H05K 5/00

(54) **LC-MODUL ZUM EINBAU IN EINEM KRAFTFAHRZEUGSTEUERGERÄT**
LC MODULE FOR INSTALLATION IN A MOTOR VEHICLE CONTROL DEVICE
MODULE LC À MONTER DANS UN APPAREIL DE COMMANDE DE VÉHICULE À MOTEUR

(30) Priorität: 08.11.2012 DE 102012110683
(43) Veröffentlichungstag der Anmeldung: 16.09.2015
(73) Patentinhaber: Conti Temic Microelectronic GmbH, 90411 Nürnberg (DE)
(72) Erfinder: ULHERR, Marcus, 90592 Schwarzenbruck (DE); MINZAT, Cristian, R-300280 Timisoara (RO)
(74) Vertreter: Bonn, Roman Klemens
(86) Internationale Anmeldenummer: PCT/DE2013/200266
(87) Internationale Veröffentlichungsnummer: WO 2014/071941

(56) Entgegenhaltungen:
- EP-A2- 1 995 439
- EP-A2- 2 043 416
- FR-A1- 2 347 851

## Beschreibung

Die Erfindung betrifft ein LC-Modul nach dem Oberbegriff des Anspruchs 1, ein Verfahren zu dessen Herstellung nach Anspruch 5 oder 6, sowie ein Steuergerät mit einem erfindungsgemäßen LC-Modul nach Anspruch 7.

Im Kraftfahrzeugbau ist es mittlerweile üblich, Steuergeräte für Motor oder Getriebe in die zu steuernde Kraftfahrzeugbaugruppe, insbesondere Motor oder Getriebe, zu integrieren. Vor allem die Getriebesteuergeräte bilden als Vorortsteuergerät eine äußerst kompakte Einheit. Im Vergleich zur konventionellen Verwendung externer Steuergeräte hat diese Anordnung enorme Vorteile im Bezug auf Qualität, Kosten, Gewicht und Funktionalität. Insbesondere resultiert daraus eine erhebliche Verringerung von Steckverbindungen und Leitungen, und somit von möglichen Ausfallursachen.

Die Integration des Steuergerätes in das Getriebe stellt hohe Anforderungen an seine thermische und mechanische Belastbarkeit. Die Funktionalität muss sowohl über einen breiten Temperaturbereich (etwa -40°C bis 150°C) als auch bei extremen mechanischen Vibrationen (bis zu 40g) gewährleistet sein.

Ein derartiges Steuergerät beschreibt die EP 1 995 439 A2. In dem Steuergerätgehäuse ist ein LC-Modul mit einer Verstärkerspule und einem Elektrolyt-Kondensator angeordnet. Das LC-Modul umfasst einen Block aus temperaturbeständigem Harz, in den eine Stromschiene aus Kupfer eingespritzt ist. Diese Stromschiene wiederum ist ausgestattet mit externen Kontakten, über die das LC-Modul mit dem Schaltungsträger des Steuergeräts elektrisch verbunden ist. Zwischen dem LC-Modul und dem Deckel des Steuergerätes ist eine elastische Platte mit hoher thermischer Leitfähigkeit angeordnet, um die von der Verstärkerspule und dem Elektrolyt-Kondensator produzierte Wärme über den Deckel effektiv in die Umgebung des Steuergerätes abzuführen. Das LC-Modul ist mit dem Gehäuse beispielsweise verschraubt.

Die Verstärkerspule und der Elektrolyt-Kondensator sind auf den Block aus temperaturbeständigem Harz geklebt, wodurch die Störanfälligkeit gegen Vibrationen reduziert werden soll.

Bei größeren und schwereren Elektronikbauteilen kann diese Maßnahme der klebenden Befestigung in Steuergeräten, wenn diese oben genannten extremen Bedingungen ausgesetzt sind, keine Langzeitstabilität garantieren.

Es ist daher eine Aufgabe der vorliegenden Erfindung, ein LC-Modul mit ausreichender Schwingungs- und Vibrationsfestigkeit zu schaffen.

Diese Aufgabe wird erfindungsgemäß gelöst durch ein LC-Modul mit den Merkmalen des Anspruchs 1. Vorteilhafte Weiterbildungen sind Gegenstand der auf den Anspruch 1 unmittelbar oder mittelbar rückbezogenen Ansprüche.

Erfindungsgemäß weist die Trägerplatte des LC-Moduls zwei räumlich getrennte Kammern auf, wobei in der ersten Kammer mindestens ein Elektrolyt-Kondensator und in der zweiten Kammer eine Spule angeordnet ist. Der Elektrolyt-Kondensator und die Spule sind in der jeweiligen Kammer zumindest teilweise in Gießmasse, insbesondere eine handelsübliche, aushärtbare Gießmasse, eingebettet und damit fixiert. Die Trägerplatte weist zwischen den zwei Kammern einen Steg auf, in dessen Bereich die Trägerplatte mit dem Gehäuse eines Steuergeräts formschlüssig oder kraftschlüssig zum Beispiel mittels einer Schraube oder eines Niet verbindbar ist.

Durch diese Verbindung des LC-Moduls mit dem Gehäuse eines Steuergerätes im Bereich des Stegs zwischen den Kammern wird sowohl die Frequenz als auch die Amplitude der Schwingungen, die durch die Vibration vor allem des Motors auf die elektronischen Bauteile des LC-Moduls übertragen werden, gedämpft. Dadurch wird die Störanfälligkeit der elektronischen Bauteile des LC-Moduls verringert und gleichzeitig deren Lebensdauer verlängert.

Vorteilhafterweise verfügt jede Kammer zumindest an seiner Innen- oder Außenfläche über Durchkontaktierungen, die eine elektrische Verbindung zwischen den Zuleitungen der elektronischen Komponenten des LC-Moduls und Komponenten, wie Aktuatoren oder Sensoren, außerhalb des LC-Moduls bzw. Steuergeräts ermöglicht.

Insbesondere sind an der Trägerplatte des LC-Moduls im Bereich des Stegs zwischen den beiden Kammern zwei Wände derart angeordnet, dass dadurch zwischen den Kammern eine dritte Kammer ausgebildet ist. Zur weiteren Verbesserung der Vibrationsfestigkeit des LC-Moduls weist dabei mindestens eine Wand dieser dritten Kammer einen Schlitz zur mechanischen "Entkoppelung" der Massen der ersten und der zweiten Kammer auf. Der Schlitz bzw. die Schlitze haben vorteilhafterweise eine V-Form.

Alternativ können in der ersten Kammer auch zwei Elektrolyt-Kondensatoren untergebracht sein.

Eine weitere Aufgabe der vorliegenden Erfindung ist es, ein Verfahren zur Herstellung eines LC-Moduls nach einem der Ansprüche 1 bis 4 zu schaffen.

Diese Aufgabe wird erfindungsgemäß gelöst durch ein Verfahren mit den Merkmalen des Anspruchs 5 oder 6.

Das erfindungsgemäße Verfahren umfasst die Schritte:
a) Bereitstellen einer Trägerplatte, mindestens eines Elektrolyt-Kondensators und einer Spule, wobei die Trägerplatte Kammern zur Aufnahme eines Elektrolyt-Kondensators und einer Spule besitzt,
b) Einlegen des Elektrolyt-Kondensators oder der Elektrolyt-Kondensatoren in die erste Kammer,
c) Einlegen der Spule in die zweite Kammer,
d) Elektrisches Verbinden der Zuleitungen eines Elektrolyt-Kondensators mit den entsprechenden Durchkontaktierungen an einer Innen- oder Außenfläche der zugehörigen Kammer,
e) Elektrisches Verbinden der Zuleitungen der Spule mit den entsprechenden Durchkontaktierungen der zugehörigen Kammer
f) Vergießen der Kammern mit Gießmasse , so dass Elektrolyt-Kondensator und Spule zumindest teilweise mit Gießmasse umgeben sind, und
g) Aushärten der Gießmasse , beispielweise mit UV-Licht.

In einem alternativen Verfahren wird zuerst die Gießmasse in die Kammern des LC-Moduls gegossen, und anschließend werden die elektronischen Bauteile eingelegt und elektrisch verbunden, wobei die Reihenfolge der Verbindungsherstellung unerheblich ist. Dieses alternative Verfahren hat den Vorteil, dass die Füllhöhe der Gießmasse in einer Kammer besser kontrolliert werden kann.

Das LC-Modul wird vorzugswese in Kraftfahrzeugsteuergeräten verbaut, wobei die Trägerplatte des LC-Moduls mit dem Gehäuse des Steuergeräts formschlüssig oder kraftschlüssig, beispielsweise mittels einer Schraube oder eines Niets, verbunden ist. Vorteilhafterweise ist der Raum zwischen dem Elektrolyt-Kondensator und dem Gehäuse bzw. der Spule und dem Gehäuse mit Wärmeleitpaste ausgefüllt ist. Diese dient zum einen insbesondere als weitere Maßnahme zur Schwingungsdämpfung, zum anderen wird dadurch die in den elektronischen Bauteilen entstehende Wärme an das Gehäuse abgeführt.

In der nachfolgenden Beschreibung werden die Merkmale und Einzelheiten der Erfindung in Zusammenhang mit den beigefügten Zeichnungen anhand von Ausführungsbeispielen näher erläutert. Dabei sind in einzelnen Varianten beschriebene Merkmale und Zusammenhänge grundsätzlich auf alle Ausführungsbeispiele übertragbar. In den Zeichnungen zeigen:
- Fig. 1: eine Draufsicht auf das LC-Modul,
- Fig. 2: eine Seitenansicht des LC-Moduls, und
- Fig. 3: einen Schnitt durch das LC-Modul und einem Gehäuseausschnitt.

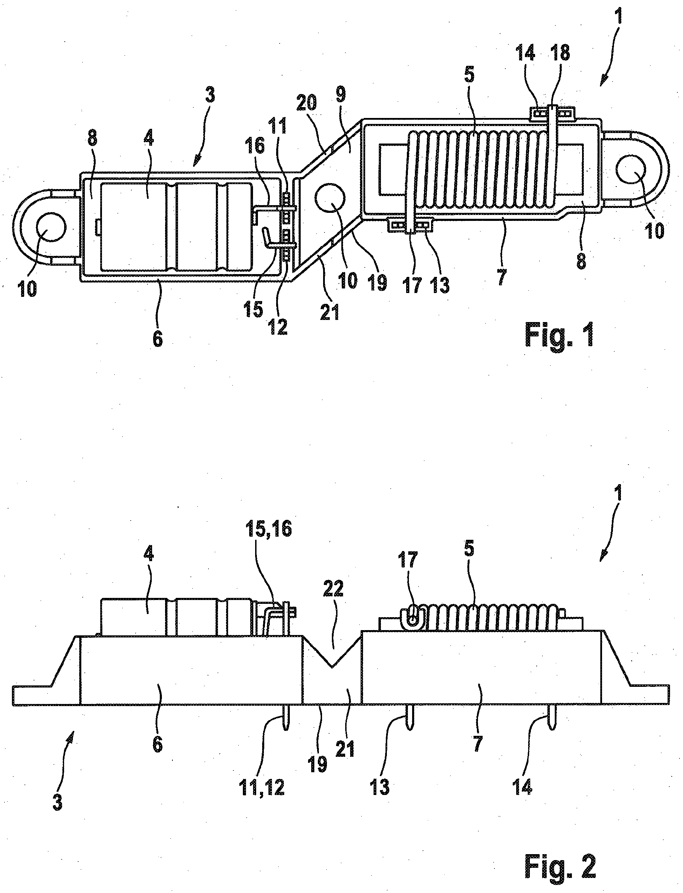

Fig. 1 zeigt ein LC-Modul 1 zum Einbau in einem Gehäuse eines Kraftfahrzeugsteuergerätes, insbesondere eines sog. Vorortsteuergerätes. Das LC-Modul 1 umfasst im wesentlichen eine Trägerplatte 3, einen Elektrolytkondensator 4 und eine Spule 5. Die Trägerplatte 3 weist im wesentlichen zwei räumlich getrennte Kammern 6, 7 auf, wobei in der ersten Kammer 6 der Elektrolyt-Kondensator 4, und in der zweiten Kammer 7 die Spule 5 angeordnet ist. Der Elektrolyt-Kondensator 4 und die Spule 5 sind zumindest teilweise mit der Gießmasse 8 umgeben. Die Gießmasse 8 ist zum Beispiel ein wärmebeständiges Harz und fixiert die elektronischen Komponenten 4 und 5 in den entsprechenden Kammern 6, 7. Die elektrischen Zuleitungen 15, 16 des Elektrolyt-Kondensators 4 sind mit den Durchkontaktierungen 11, 12 elektrisch verbunden, zum Beispiel verschweißt oder verlötet. Die Durchkontaktierungen 11, 12 sind hier an einer Innenfläche der Kammer 6 integriert. Die elektrischen Zuleitungen 17, 18 der Spule 5 sind mit den Durchkontaktierungen 13,14 elektrisch verbunden, wobei die Durchkontaktierungen 13,14 hier an einer Außenfläche der Kammer 7 angeordnet sind.

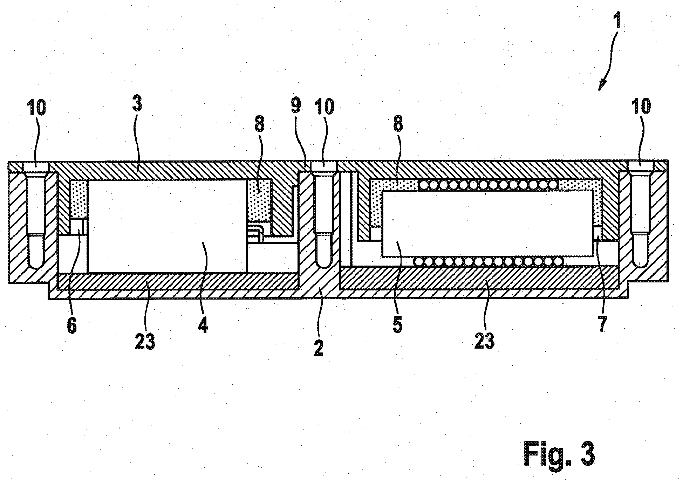

Die Durchkontaktierungen 11, 12, 13, 14 können jeweils wahlweise an einer Innenfläche oder einer Außenfläche der entsprechenden Kammer 6, 7 angeordnet sein. Die Durchkontaktierungen 11, 12, 13, 14 ermöglichen die elektrische Verbindung zwischen den Zuleitungen 15, 16,17, 18 und Komponenten außerhalb des LC-Moduls bzw. des Steuergeräts. Zwischen den beiden Kammern 6,7 weist die Trägerplatte 3 einen Steg 9 auf. In diesem Steg 9 ist insbesondere eine Befestigungsvorrichtung in Form eines kreisrunden Durchbruchs 10 angeordnet. Die Form kann von der Kreisform abweichen. Mittels dieses Durchbruchs 10 ist das LC-Modul 1 mit dem Gehäuse 2 des Steuergeräts formschlüssig oder kraftschlüssig, beispielsweise mittels einer Schraube oder eines Niet, verbindbar. Dies ist insbesondere in Figur 3 dargestellt.

Diese formschlüssige oder kraftschlüssige Verbindung des LC-Moduls 1 mit dem Gehäuse 2 im Bereich des Stegs 9 zwischen den Kammern 6, 7 liefert den größten Beitrag zur Dämpfung der Schwingungen, sowohl bezüglich der Frequenz als auch der Amplitude, die durch die Vibration vor allem des Motors auf das LC-Modul, und damit auf den Elektrolyt-Kondensator 4 und die Spule 5 übertragen werden.

Die Dämpfung der Schwingungen wird umso wichtiger, je größer und schwerer die in den Kammern 6 und 7 verbauten elektronischen Bauteile 4, 5 sind, insbesondere für größere Elektrolyt-Kondensatoren 4 mit einem Becherdurchmesser größer gleich 18 mm und einem Gewicht ab 12g, bzw. für Spulen 5 mit einem Gewicht ab 40g.

Durch diese Anordnung wird die Störanfälligkeit der elektronischen Bauteile 4, 5 des LC-Moduls 1 verringert und gleichzeitig deren Lebensdauer verlängert. Zusätzliche Verbindungen des LC-Moduls 1 mit dem Gehäuse 2 können auch insbesondere durch die Öffnungen 10, die je an der Trägerplatte 3 an den dem Steg 9 gegenüberliegenden Seite der Kammer 6 bzw. 7 angeordnet sind, hergestellt werden. Der Beitrag der äußeren Befestigungsvorrichtungen 10 zur Schwingungsdämpfung ist aber geringer als der durch die Verbindung im Bereich des Stegs 9 zwischen den Kammern 6, 7..

Insbesondere sind an der Trägerplatte 3 des LC-Moduls 1 im Bereich des Stegs 9 zwischen den beiden Kammern 6, 7 zwei Wände 20, 21 derart angeordnet, dass dadurch zwischen den Kammern 6, 7 eine dritte Kammer 19 ausgebildet ist.

Fig. 2 zeigt eine Seitenansicht des LC-Moduls 1. Zur weiteren Verbesserung der Vibrationsfestigkeit des LC-Moduls 1 weist dabei mindestens eine Wand 20, 21 der dritten Kammer 19 einen Schlitz 22 zur mechanischen "Entkoppelung" der Massen in der ersten Kammer 6 und der zweiten Kammer 7 auf. Der Schlitz bzw. die Schlitze 22 haben vorteilhafterweise eine V-Form, können aber auch beispielsweise rechteckig ausgeführt sein.

Fig. 3 zeigt einen Schnitt durch das LC-Modul 1 und ein mit dem LC-Modul 1 verbundenen Gehäuse 2 eines Steuergerätes, wobei das Gehäuse 2 nur ausschnittweise dargestellt ist. Insbesondere ist zwischen dem Elektrolyt-Kondensator 4 und dem Gehäuse 2 bzw. zwischen der Spule 5 und dem Gehäuse 2 Wärmeleitpaste angeordnet. Diese dient zum einen insbesondere als weitere Maßnahme der Schwingungsdämpfung, zum anderen wird dadurch die in den elektronischen Bauteilen 4, 5 entstehende Wärme zuverlässig an das Gehäuse abgeführt.

Abschließend ist zu sagen, dass die Anordnung der Zuleitungen 15, 16, 17, 18 der elektronischen Bauteile 4, 5 nicht auf die in den Figuren gezeigte Weise festgelegt ist.

### Bezugszeichenliste:

- 1: LC-Modul
- 2: Gehäuse eines Kraftfahrzeugsteuergerätes
- 3: Trägerplatte
- 4: Elektrolyt-Kondensator
- 5: Spule
- 6: Erste Kammer
- 7: Zweite Kammer
- 8: Gießmasse
- 9: Steg zwischen den Kammern
- 10: Befestigungsvorrichtung
- 11, 12: Durchkontaktierungen der ersten Kammer
- 13, 14: Durchkontaktierungen der zweiten Kammer
- 15, 16: Elektrische Zuleitungen des Elektrolyt-Kondensators
- 17, 18: Elektrische Zuleitungen der Spule
- 19: Dritte Kammer
- 20, 21: Wand der dritten Kammer
- 22: Schlitz in Wand der dritten Kammer
- 23: Wärmeleitpaste

## Patentansprüche

1. LC-Modul (1) zum Einbau in einem Gehäuse (2) eines Kraftfahrzeugsteuergerätes, wobei das LC-Modul (1) eine Trägerplatte (3), mindestens einen Elektrolyt-Kondensator (4) und eine Spule (5) umfasst, **dadurch gekennzeichnet, dass**
die Trägerplatte (3) zwei räumlich getrennte Kammern (6, 7) aufweist, wobei in der ersten Kammer (6) der Elektrolyt-Kondensator (4), und in der zweiten Kammer (7) die Spule (5) angeordnet ist,
wobei der Elektrolyt-Kondensator (4) und die Spule (5) in den Kammern (6, 7) zumindest teilweise mit Gießmasse (8) umgeben sind,
die Trägerplatte (3) zwischen den zwei Kammern (6, 7) einen Steg (9) aufweist, und
die Trägerplatte (3) zumindest im Bereich des Stegs (9) mit dem Gehäuse (2) des Steuergeräts formschlüssig oder kraftschlüssig verbindbar ist.

2. LC-Modul (1) nach Anspruch 1 einem der vorherigen Ansprüche, **dadurch gekennzeichnet, dass** jede Kammer (6, 7) an einer Innen- oder Außenfläche Durchkontaktierungen (11, 12, 13, 14) aufweist, die eine elektrische Verbindung zwischen Zuleitungen (15, 16, 17, 18) des Elektrolyt-Kondensators (4) und der Spule (5) und Komponenten außerhalb des LC-Moduls ermöglicht.

3. LC-Modul (1) nach einem der vorherigen Ansprüche, **dadurch gekennzeichnet, dass** an der Trägerplatte (3) im Bereich des Stegs (9) zwischen den beiden Kammern (6, 7) zwei Wände (20, 21) derart angeordnet sind, dass dadurch zwischen den Kammern (6, 7) eine dritte Kammer (19) ausgebildet ist, wobei mindestens eine Wand (21, 22) einen Schlitz (24) aufweist.

4. LC-Modul (1) nach einem der vorherigen Ansprüche, **dadurch gekennzeichnet, dass** in der ersten Kammer (6) zwei Elektrolyt-Kondensatoren (4) angeordnet sind.

5. Verfahren zur Herstellung eines LC-Moduls nach Anspruch 1 mit den Schritten:
a) Bereitstellen einer Trägerplatte (3), mindestens eines Elektrolyt-Kondensators (4) und einer Spule (5),
b) Einlegen des Elektrolyt-Kondensators (4) in die erste Kammer (6),
c) Einlegen der Spule (5) in die zweite Kammer (7),
d) Elektrisches Verbinden der Zuleitungen (15, 16) des Elektrolyt-Kondensators (4) mit den Durchkontaktierungen (11, 12),
e) Elektrisches Verbinden der Zuleitungen (17, 18) der Spule (5) mit den Durchkontaktierungen (13, 14),
f) Vergießen der Kammern (6, 7) mit Gießmasse (8), und
g) Aushärten der Gießmasse (8).

6. Verfahren zur Herstellung eines LC-Moduls nach Anspruch 1 mit den Schritten:
a) Bereitstellen einer Trägerplatte (3), mindestens eines Elektrolyt-Kondensators (4) und einer Spule (5),
b) Vergießen der Kammern (6, 7) mit Gießmasse (8),
c) Einlegen des Elektrolyt-Kondensators (4) in die Kammer (6),
d) Einlegen der Spule (5) in die Kammer (7),
e) Elektrisches Verbinden der Zuleitungen (15, 16) des Elektrolyt-Kondensators (4) mit den Durchkontaktierungen (11, 12),
f) Elektrisches Verbinden der Zuleitungen (17, 18) der Spule (5) mit den Durchkontaktierungen (13, 14), und
g) Aushärten der Gießmasse (8).

7. Kraftfahrzeugsteuergerät, wobei ein LC-Modul (1) gemäß Anspruch 1 zumindest im Bereich des Stegs (9) der Trägerplatte (3) des LC-Moduls (1) mit dem Gehäuse (2) des Steuergeräts formschlüssig oder kraftschlüssig verbunden ist.

8. Kraftfahrzeugsteuergerät nach Anspruch 7, **dadurch gekennzeichnet, dass** der Raum zwischen dem Elektrolyt-Kondensator (4) und dem Gehäuse (2) bzw. der Spule (5) und dem Gehäuse (2) mit Wärmeleitpaste (23) ausgefüllt ist.

## Claims

1. LC module (1) for installing in a housing (2) of a motor vehicle control device, wherein the LC module (1) comprises a carrier plate (3), at least one electrolytic capacitor (4) and a coil (5), **characterized in that**
the carrier plate (3) comprises two chambers (6, 7) that are spatially separated from one another, wherein the electrolytic capacitor (4) is arranged in the first chamber (6), and the coil (5) is arranged in the second chamber (7),
wherein the electrolytic capacitor (4) and the coil (5) are at least in part surrounded by casting compound (8) in the chambers (6, 7),
the carrier plate (3) comprises a connecting piece (9) between the two chambers (6, 7), and
the carrier plate (3) can be connected at least in the region of the connecting piece (9) to the housing (2) of the control device in a positive-locking manner or a non-positive-locking manner.

2. LC module (1) according to Claim 1 any one of the preceding claims, **characterized in that** each chamber (6, 7) comprises through-going contacts (11, 12, 13, 14) on an inner surface or outer surface and said through-going contacts render possible an electrical connection between supply lines (15, 16, 17, 18) of the electrolytic capacitor (4) and the coil (5) and components outside the LC module.

3. LC module (1) according to any one of the preceding claims, **characterized in that** two walls (20, 21) are arranged on the carrier plate (3) in the region of the connecting piece (9) between the two chambers (6, 7) in such a manner that, as a consequence, a third chamber (19) is embodied between the chambers (6, 7), wherein at least one wall (21, 22) comprises a slot (24).

4. LC module (1) according to any one of the preceding claims, **characterized in that** two electrolytic capacitors (4) are arranged in the first chamber (6).

5. Method for producing an LC module according to Claim 1 having the steps:
a) Providing a carrier plate (3), at least one electrolytic-capacitor (4) and a coil (5),
b) Inserting the electrolytic capacitor (4) into the first chamber (6),
c) Inserting the coil (5) into the second chamber (7),
d) Electrically connecting the supply lines (15, 16) of the electrolytic capacitor (4) to the through-going contacts (11, 12),
e) Electrically connecting the supply lines (17, 18) of the coil (5) to the through-going contacts (13, 14),
f) Filling the chambers (6, 7) with casting compound (8), and
g) Thermosetting the casting compound (8).

6. Method for producing an LC module according to Claim 1 having the steps:
a) Providing a carrier plate (3), at least one electrolytic-capacitor (4) and a coil (5),
b) Filling the chambers (6, 7) with casting compound (8),
c) Inserting the electrolytic capacitor (4) into the chamber (6),
d) Inserting the coil (5) into the chamber (7),
e) Electrically connecting the supply lines (15, 16) of the electrolytic capacitor (4) to the through-going contacts (11, 12),
f) Electrically connecting the supply lines (17, 18) of the coil (5) to the through-going apertures (13, 14), and
g) Thermosetting the casting compound (8).

7. Motor vehicle control device, wherein an LC module (1) in accordance with Claim 1 is connected to the housing (2) of the control device in a positive-locking manner or a non-positive-locking manner at least in the region of the connecting piece (9) of the carrier plate (3) of the LC module (1).

8. Motor vehicle control device according to Claim 7, **characterized in that** the space between the electrolytic capacitor (4) and the housing (2) or rather the coil (5) and the housing (2) is filled with heat-conducting paste (23).

## Revendications

1. Module LC (1) destiné à être installé dans un boîtier (2) d'un contrôleur de véhicule automobile, le module LC (1) comprenant une plaque porteuse (3), au moins un condensateur électrolytique (4) et une bobine (5), **caractérisé en ce que** la plaque porteuse (3) possède deux chambres (6, 7) séparées dans l'espace, le condensateur électrolytique (4) étant disposé dans la première chambre (6) et la bobine (5) dans la deuxième chambre (7),
le condensateur électrolytique (4) et la bobine (5) étant au moins partiellement entourés d'une masse de surmoulage (8) dans les chambres (6, 7),
la plaque porteuse (3) possède une nervure (9) entre les deux chambres (6, 7), et
la plaque porteuse (3) peut être reliée au boîtier (2) du contrôleur par complémentarité de formes ou par force au moins dans la zone de la nervure (9).

2. Module LC (1) selon la revendication 1 une des revendications précédentes, **caractérisé en ce que** chaque chambre (6, 7) possède sur une surface intérieure ou extérieure des contacts traversants (11, 12, 13, 14) qui permettent une liaison électrique entre les lignes d'arrivée (15, 16, 17, 18) du condensateur électrolytique (4) et de la bobine (5) et des composants en-dehors du module LC.

3. Module LC (1) selon l'une des revendications précédentes, **caractérisé en ce que** deux parois (20, 21) sont disposées sur la plaque porteuse (3) dans la zone de la nervure (9) entre les deux chambres (6, 7), de telle sorte qu'une troisième chambre (19) est ainsi formée entre les chambres (6, 7), au moins une paroi (21, 22) possédant une fente (24).

4. Module LC (1) selon l'une des revendications précédentes, **caractérisé en ce que** deux condensateurs électrolytiques (4) sont disposés dans la première chambre (6).

5. Procédé de fabrication d'un module LC selon la revendication 1, comprenant les étapes suivantes :
a) mise à disposition d'une plaque porteuse (3), d'au moins un condensateur électrolytique (4) et d'une bobine (5),
b) introduction du condensateur électrolytique (4) dans la première chambre (6),
c) introduction de la bobine (5) dans la deuxième chambre (7),
d) connexion électrique des lignes d'arrivée (15, 16) du condensateur électrolytique (4) avec les contacts traversants (11, 12),
e) connexion électrique des lignes d'arrivée (17, 18) de la bobine (5) avec les contacts traversants (13, 14),
f) surmoulage des chambres (6, 7) avec une masse de surmoulage (8) et
g) durcissement de la masse de surmoulage (8).

6. Procédé de fabrication d'un module LC selon la revendication 1, comprenant les étapes suivantes :
a) mise à disposition d'une plaque porteuse (3), d'au moins un condensateur électrolytique (4) et d'une bobine (5),
b) surmoulage des chambres (6, 7) avec une masse de surmoulage (8),
c) introduction du condensateur électrolytique (4) dans la chambre (6),
d) introduction de la bobine (5) dans la chambre (7),
e) connexion électrique des lignes d'arrivée (15, 16) du condensateur électrolytique (4) avec les contacts traversants (11, 12),
f) connexion électrique des lignes d'arrivée (17, 18) de la bobine (5) avec les contacts traversants (13, 14), et
g) durcissement de la masse de surmoulage (8).

7. Contrôleur de véhicule automobile, avec lequel un module LC (1) selon la revendication 1 est relié au boîtier (2) du contrôleur par complémentarité de formes ou par force au moins dans la zone de la nervure (9) de la plaque porteuse (3) du module LC (1).

8. Contrôleur de véhicule automobile selon la revendication 7, **caractérisé en ce que** l'espace entre le condensateur électrolytique (4) et le boîtier (2) ou entre la bobine (5) et le boîtier (2) est rempli de pâte thermoconductrice (23).
